# EUROPEAN PATENT SPECIFICATION

(11) **EP 1 005 078 B1**
(45) Date of publication and mention of the grant of the patent: **21.01.2004**
(21) Application number: 99122376.9
(22) Date of filing: 10.11.1999
(51) Int. Cl.: H01L 21/768

(54) **Process for forming a conductive structure**
Verfahren zur Herstellung einer leitenden Struktur
Méthode de formation d'une structure conductrice

(30) Priority: 24.11.1998 US 198922
(43) Date of publication of application: 31.05.2000
(73) Proprietor: MOTOROLA, INC., Schaumburg, IL 60196 (US)
(72) Inventor: Mikkola, Robert D., Austin, Texas 78739 (US); Chowdury, Rina, Austin, Texas 78746 (US)
(74) Representative: Gibson, Sarah Jane

(56) References cited:
- WO-A-98/27585
- US-A- 5 028 513
- "Resist Residue and Oxide Removal Prior to Plating, Lift Off and Etching" IBM TECHNICAL DISCLOSURE BULLETIN, vol. 21, no. 5, October 1978 (1978-10), pages 2108-2111, XP002131959

## Description

### Field of the Invention

The invention relates in general to processes for forming semiconductor devices, and more particularly, to processes for forming semiconductor devices having interconnects.

### Related Art

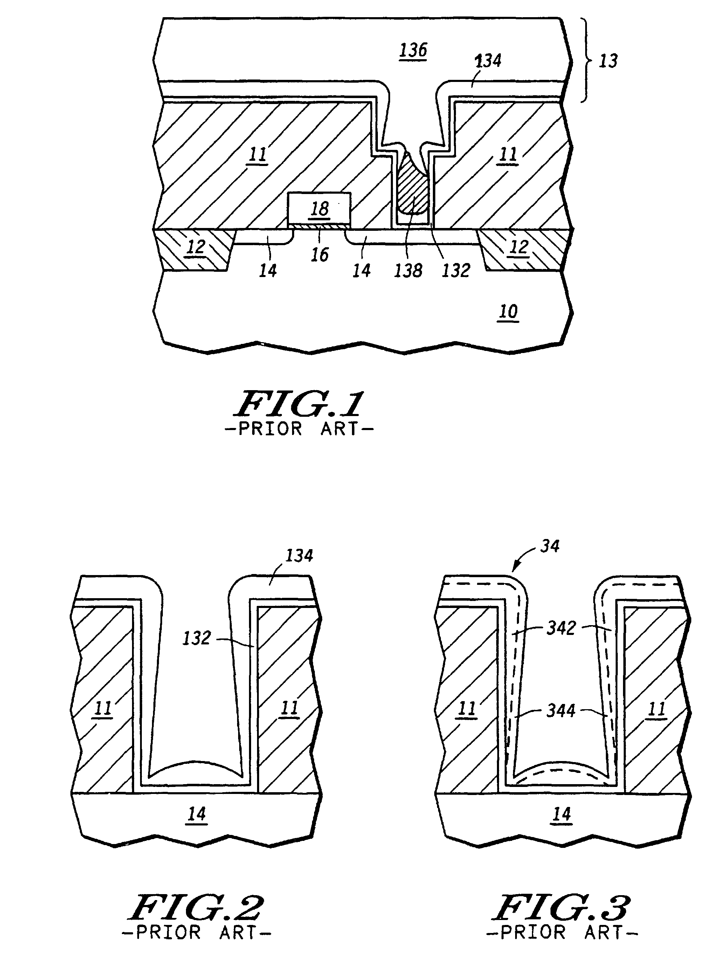

Semiconductor devices continue to be shrunk to smaller dimensions. The aspect ratio of openings is becoming large compared to older devices. FIG. 1 illustrates a semiconductor device substrate 10, field isolation regions 12, and doped regions 14. Overlying a portion of the substrate 10 and the doped regions 14 are a gate dielectric layer 16 and a gate electrode 18. In forming the contact to one of the doped regions 14, an interlevel dielectric (ILD) layer 11 is formed and a dual inlaid opening is then formed that extends through the ILD layer 11. The dual inlaid opening includes a via portion and an interconnect trench portion. The length of the via portion (along the walls) is at least as large as its width.

Conductive layer 13 is formed over the ILD layer 11 and within the dual inlaid opening. The conductive layer 13 is formed by sequentially depositing conductive films. A barrier film 132, such as tantalum or a tantalum-containing material, and a copper seed film 134 are formed over the ILD layer 11 and within the dual inlaid opening. The films are formed using ionized metal plasma physical vapor deposition (IMP PVD). FIG. 2 includes an enlarged illustration of the films within the dual inlaid opening immediately after formation. Although the barrier film 132 is deposited substantially conformally, the copper seed film is nonconformal. On flat exposed surfaces, the copper seed film 134 has a thickness of approximately 100-200 nanometers. At approximately ten percent step coverage, the thickness of the copper seed film 134 near the bottom of the opening may be only 10 nanometers.

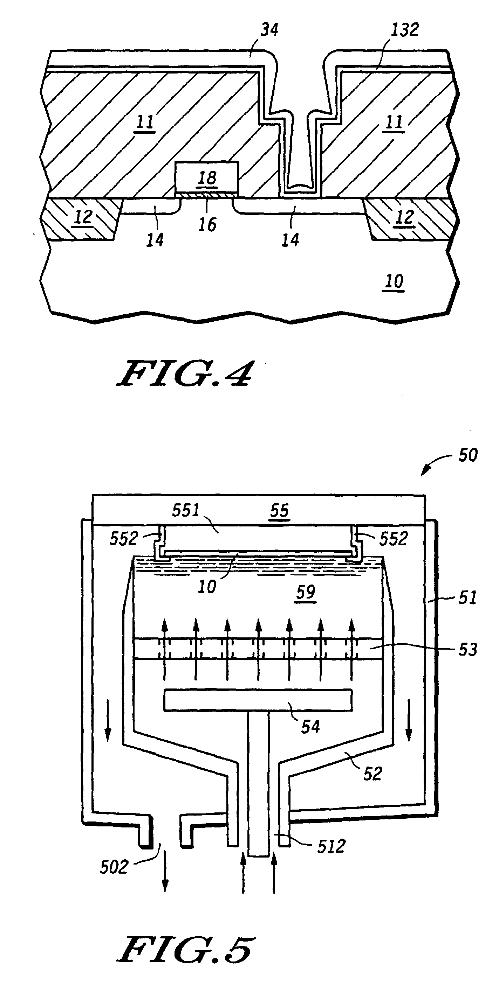

After formation of the copper seed film, the substrate 10 is subsequently removed from the IMP PVD system and exposed to an oxidizing environment, such as air. The deposited copper seed film 134 is converted to a partially oxidized copper seed film 34 as shown in FIG. 3. The oxidized seed film 34 includes a residual unoxidized copper portion 342 and an oxidized copper portion 344. Typically, the oxidized portion 344 is in the form of cuprous oxide (Cu₂O), although cupric oxide (CuO) could additionally or alternatively be formed. The oxidized portion 344 is substantially uniform in its thickness that is typically approximately 5-10 nanometers depending on the length and conditions of the oxidizing exposure. Each of longer exposure, higher temperature, and more corrosive ambient converts more of the copper to the oxidized copper portion 344. As can be seen in FIG. 3, the thickness of the residual copper portion 342 gets very thin near the bottom and, at some locations, is discontinuous.

The copper seed layer must be activated prior to plating. Copper can plate onto copper (not oxidized) but in the presence of copper oxides it will not plate adherent copper deposits. The substrate 10 is placed into a plater having a plating solution. The substrate is allowed to dwell before plating starts. By dwell, it is meant that the substrate is in contact with the plating bath without any external potential applied to the plating solution. The plating bath typically contains cupric sulfate, sulfuric acid, and chloride ions. The bath is highly acidic and typically has a pH of less than one. The solution removes the oxide portion 344 of the copper seed film 34. During this processing step, in addition to removing the oxides portions 344, portions of the residual copper portion 342 are converted to Cu²⁺ ions and are also removed. A discontinuous seed film 34 now exists.

Plating is performed to form the plated copper film 136 as shown in FIG. 1. However, because some of the copper seed film has been removed near the bottom of the opening, a void 138 is formed during plating. This voiding can result in reliability problems, cause electrical opens, or result in the formation of highly resistive contacts. Other chemicals are typically present in the plating bath, such as brighteners and levelers. However, their presence does not appear to significantly change the void formation 138 as shown in FIG. 1.

### Brief Description of the Drawings

The present invention is illustrated by way of example and not limitation in the accompanying figures, in which like references indicate similar elements, and in which:
FIG. 1 includes an illustration of a cross-sectional view of a portion of a semiconductor device illustrating a void within a conductive layer (prior art);
FIG. 2 includes an illustration of the substrate of FIG. 1 immediately after formation of the seed film (prior art);
FIG. 3 includes an illustration of the seed film shown in FIG. 2 after the seed film has been partially oxidized (prior art);
FIG. 4 includes an illustration of a portion of a semiconductor device substrate after forming a copper seed film within a dual inlaid opening;
FIG. 5 includes an illustration of a cross-sectional view of a portion of a recovery bath used in accordance with an embodiment of the present invention;
FIG. 6 includes a plot of potential versus time illustrating the reactions occurring within the recovery bath.
FIG. 7 includes an illustration of a portion of the substrate of FIG. 4 after plating a copper film over the recovered seed film;
FIG. 8 includes an illustration of a cross-sectional view of the substrate of FIG. 7 after polishing the portions of the conductive layer to form an interconnect; and
FIG. 9 includes an illustration of a cross-sectional view of the substrate of FIG. 8 after forming a substantially completed device.

Skilled artisans appreciate that elements in the figures are illustrated for simplicity and clarity and have not necessarily been drawn to scale. For example, the dimensions of some of the elements in the figures may be exaggerated relative to other elements to help to improve understanding of embodiments of the present invention.

### Detailed Description

A process for forming a semiconductor device has been developed that reduces the likelihood of forming voids within conductive layers. A seed film is formed over a substrate, wherein a portion of the seed film is oxidized. The portion of the seed film is reduced to form a recovered seed film. A conductive film is formed over the seed film. The process is particularly well suited for use in semiconductor devices having openings with high aspect ratios. The present invention is defined in the claims and is better understood after reading the embodiments that are described herein.

FIG. 4 includes an illustration of a cross-sectional view of a portion of a semiconductor device substrate 10. As used in this specification, a semiconductor device substrate includes a monocrystalline semiconductor wafer, a semiconductor-on-insulator wafer, or any other substrate used to form semiconductor devices. The device also includes field isolation regions 12, doped regions 14, a gate dielectric layer 16, a gate electrode 18, and an ILD layer 11. A dual inlaid opening is formed within the ILD layer 11. Although not shown, ILD layer 11 typically includes a plurality of films which aid in the formation of the dual inlaid opening. The dual inlaid opening includes an interconnect portion and a via portion. For the via portion, the height of its walls are at least two times greater than its width at the bottom of the opening.

A barrier film 132 is then formed over the ILD layer 11 and within the dual inlaid opening. The barrier film 132 includes any one or more of the following tantalum, titanium, molybdenum, cobalt, nitrides of those materials, or the like. In one particular embodiment, the barrier film 132 is a tantalum film having a thickness in a range of approximately 20 to 50 nanometers. A copper seed film is then formed by IMP PVD (or alternatively by hollow cathode magnatron (HCM) or collimated PVD) and is subsequently exposed to air to form the oxidized seed film 34 having a residual unoxidized portion and an oxidized portion similar to film shown in FIG. 3. The seed film 34 is typically in a range of 50 to 300 nanometers thick on the flat, exposed, uppermost surface of the ILD layer 11. Unlike the barrier layer 132 that is substantially conformal, the seed film 34 is very non-conformal within the opening. Within the dual inlaid opening, the seed film 134 may have a reduced thickness in a range of approximately 5 to 30 nanometers near the bottom of the opening near doped region 14. In aggressively scaled devices, this thickness is no more than approximately 10 nanometers. The oxidized portion is typically Cu₂O but may include CuO, too. The oxidized portion typically has a thickness in a range of approximately 4-10 nanometers. The residual unoxidized copper portion may be discontinuous near the bottom of the dual inlaid opening. The processing up to this point in the process is conventional.

The substrate 10 is then placed into a recovery bath to convert the oxide portion back to copper without significantly removing any copper within the seed film 34. Simply put, the seed film 34 is being returned close to its state before air exposure (changing oxidized seed film 34 closer to the deposited seed film 134 as seen in FIG. 2).

FIG. 5 includes an illustration of a cross-sectional view of the recovery bath system 50. The system 50 includes a chamber 51 with an outlet port 502. The system further includes a cup 52 that has an inlet port 512 for receiving an electrolyte solution and a diffuser 53 within the cup 52. An anode 54 lies between the cup 52 and the diffuser 53. The system 50 further includes a head 55 that has a turn table 551 and clamp fingers 552. Those clamp fingers 552 are the cathode contacts for the system 50 and are typically made of platinized titanium. Alternatively, a platinized niobium compound could be used for the fingers 552.

In operation of the system 50, the electrolyte solution 59 flows in a filtration loop and enters the cup 52 through an inlet port 512 and flows by the anode 54. The anode 54 includes a substantially inert material. As used in this specification, substantially inert means that the material of the anode does not significantly dissolve into the solution as ions. Therefore, the electrolyte solution has no more than approximately one part per million of the anode material in ionic form within the solution. In this particular embodiment, the anode 54 includes platinum, niobium, platinum or niobium-containing material, combinations thereof, or the like. The electrolyte solution 59 flows through the diffuser 53 to reach the substrate 10. The electrolyte solution 59 eventually flows over the sides of the cup 52, down between the walls of the cup 52 and the chamber 51, and through the outlet port 502. In this particular embodiment, the recovery bath system is not plating but is used to reduce the copper oxide to copper without plating any additional materials onto the substrate. It is recovering the copper that would otherwise be removed during the "dwell" before plating.

The material used in the electrolyte solution 59 should not corrode the seed film. The electrolyte solution 59 includes cations and anions of an electrolyte material. Typically, the cations include sodium, potassium, aluminum, ammonium, or the like. The anions include fluoride, carbonate, bicarbonate, sulfate, phosphite, phosphate, borate, citrate, or the like. The actual material chosen can be selected based on performance, contamination concerns, safety, or the like. For example, if metallic contamination is a concern, ammonium sulfate or a quaternary ammonium salt (e.g., tetramethyl ammonium sulfate, tetraethyl ammonium sulfate, etc.) can be used. In one specific embodiment, sodium bicarbonate (NaHCO₃) is used (sodium cations and bicarbonate anions).

The concentration of the material in the electrolyte solution is in a range of approximately 0.05-1.00 molar. In one embodiment, the concentration is approximately 0.1 molar. The pH of the electrolyte solution 59 is at least approximately 5 and more typically is in range of approximately 6-8. Although no upper limit is known, if the pH is too high, the copper from the residual portion may possibly be tarnished or oxidized due to the aggressive pH conditions.

The recovery bath is operated at a current density in a range of approximately 0.05-5.00 milliamperes per square centimeter. At higher current densities, the reduction of the oxidized portion of the seed film 34 is too fast to be reproducibly controlled. At lower current densities, there is an increased risk of eroding the seed film 34. The recovery time is usually less than a minute and more typically is in a range of approximately 5-20 seconds. During the recovery operation, the substrate is typically the cathode and is at a negative potential relative to the anode 54. A current density of approximately 0.1 milliamperes per square centimeter gives reasonably good control over the recovery operation length.

During the reduction of the oxidized seed film 34, a few reduction reactions can occur as seen in FIG. 6. At a potential of approximately -0.4 volts Cu₂O is reduced to copper; at approximately -0.6 volts CuO is reduced to copper; and at approximately -1.1 volts, hydrogen is evolved due to the oxidation of water. Typically, the recovery process is continued until there is some hydrogen evolution. The time until hydrogen evolution occurs varies depending on current density. At a current density of 0.1 milliamperes per square centimeter the time until hydrogen evolution is approximately 15 seconds. Due to safety reasons, the amount of hydrogen evolution should be kept low. Should the operation described become automated, detection end points similar to the conversions seen at the cuprous oxide and cupric oxide stages can be used to monitor the operation. Extra time beyond reaching endpoint can be used to account for nonuniformities in the current density across the substrate and other parameters.

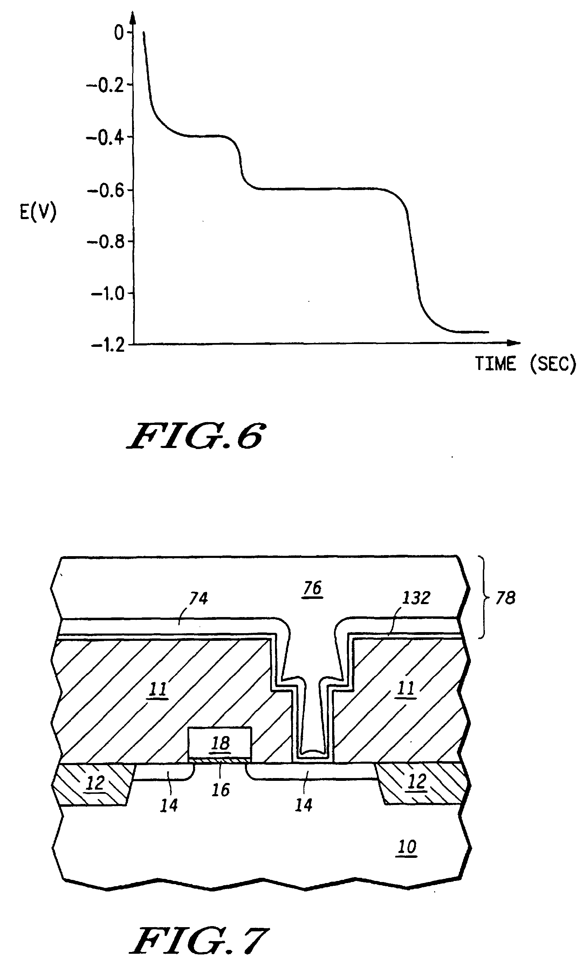

At the end of the recovery operation, the current is terminated. At least 50 percent, and usually more, of the oxidized portion is reduced to copper. As illustrated in FIG. 7, the recovered seed film 74 has been formed that has a thickness close to the seed film immediately after deposition.

Following the recovery operation, the substrate is typically spray rinsed and then inserted into a copper plating system as quickly as possible. The rinse step is typically performed using deionized water. Although the substrate can remain wet during the transfer, alternatively it could be dried. Regardless of whether the substrate is dried, the time between rinsing and placing the substrate into the plating bath should be no more than approximately two minutes, and generally, should be less than one minute. The quick rinsing and transfer keeps the oxidation of the recovered seed film 74 to a minimum.

After the seed film recovery and rinsing has occurred, the substrate is placed into a conventional plating system, and an electroplated copper film 76 is then formed over the recovered seed film 74 to form the conductive layer 78 as illustrated in FIG. 7. There will be no or minimum dwell time before plating is started. Typically, the only time lapse between placing the substrate into the plating bath and starting plating will only be enough to stabilize the operating conditions (turntable rotation rate, plating solution flow rate, etc.) in the plating bath before the current is started. This time is typically no more than one minute and usually is less than 10 seconds. The current is then applied and plating begins. The film 76 is mostly copper although some impurities can lie within the film 76 (e.g. magnesium, indium, chromium, etc.) can be included to improve its properties as used in semiconductor devices. The plating of the copper film 76 is conventional.

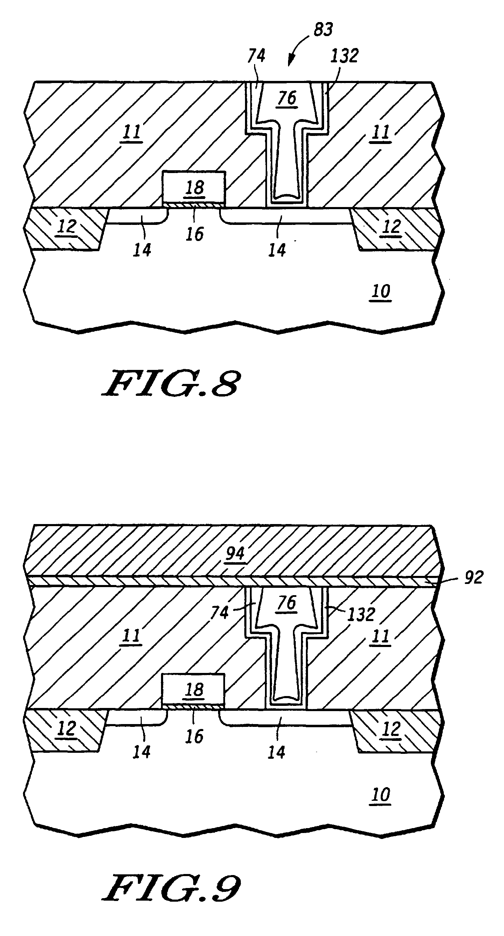

A polishing step is used to remove portions of the films 76, 74, and 132 overlying the interlevel dielectric level 11 to form interconnect 83 in FIG. 8. Processing continues to form the substantially completed device as illustrated in FIG. 9. A capping layer 92 is formed and typically includes a nitride material, such as silicon nitride. Subsequently, a passivation layer 94 is then formed over the capping layer 92. Although not illustrated, other electrical connections are made to the gate electrode 18 and the other doped region 14. Additionally, if other levels of interconnects are needed, they are formed in a manner similar to those that have been described.

The recovery and plating baths are types of reactors. Although the copper film 76 is electroplated, the recovered seed film 74 can be used when subsequently selectively depositing a conductive film, whether electroplating or another formation process (e.g., chemical vapor deposition) is used.

Embodiments of the present invention allow copper interconnects to be formed using electroplating with a reduced likelihood of void formation during copper plating. A plating system can be modified to have a recovery bath and a plating bath on one tool (platform). This allows quicker transfer of the wafers from the recovery bath to the plating bath. This tool configuration minimizes the formation of oxides from the seed film before plating the electroplated film.

The problem seen with the dwell time before electroplating, as used in the prior art, is overcome. While the dwell activates the seed film, it removes the oxide rather than reducing it. The seed film will be significantly thinner when it is activated by dwelling as opposed to reducing.

The processes described herein are advantageous in the scaling of semiconductor devices. As the dimensions shrink, the thickness of the seed film likewise needs to be decreased. As the seed film thickness is decreased below 100 nanometers, the thickness of the seed film at the bottom of high aspect ratio openings likewise decreases. The likelihood of forming voids as seen in the prior art increases with scaling. The processes previously described recover the copper from the oxidized portion of the seed film 34 allowing the formation of the plated material within the opening without having to worry about the formation of voids.

The process does not require the use of electroless metal deposition of the seed film. Electroless metal depositions are more likely to incorporate unwanted impurities within the seed film. Therefore, the process described herein provides a better quality seed film.

The process and apparatus used as described herein can be modified without using exotic materials or radical changes in existing equipment. The impact on cycle time is believed to be minimal as some type of activation step needs to be performed before plating. Yield increases as the likelihood of void formation is reduced.

In the foregoing specification, the invention has been described with reference to specific embodiments. However, one of ordinary skill in the art appreciates that various modifications and changes can be made without departing from the scope of the present invention as set forth in the claims below. Accordingly, the specification and figures are to be regarded in an illustrative rather than a restrictive sense, and all such modifications are intended to be included within the scope of present invention.

Benefits, other advantages, and solutions to problems have been described above with regard to specific embodiments. However, the benefits, advantages, solutions to problems, and any element(s) that may cause any benefit, advantage, or solution to occur or become more pronounced are not to be construed as a critical, required, or essential feature or element of any or all the claims. As used herein, the terms "comprises," "comprising," or any other variation thereof, are intended to cover a non-exclusive inclusion, such that a process, method, article, or apparatus that comprises a list of elements does not include only those elements but may include other elements not expressly listed or inherent to such process, method, article, or apparatus.

## Claims

1. A process for forming a semiconductor device **characterised by**:
forming a seed film (34) over a substrate (10), wherein a portion of the seed film (34) is oxidized;
reducing the portion of the seed film (34); and
forming a conductive film (76) over the seed film (34).

2. The process of claim 1, further **characterised by** exposing the seed film (34) to air before reducing the portion of the seed film (34).

3. The process of claim 1, further **characterised by** forming a patterned insulating layer (11) over the substrate (10) before forming the seed layer (34), wherein the patterned insulating layer (11) includes an opening.

4. The process of claim 3, wherein:
the opening has a height and a width; and
the height divided by the width is at least approximately two.

5. The process of claim 3, wherein:
the opening is a dual inlaid opening that includes a via portion defined by a bottom and walls abutting the opening;
the via portion has a height and a width; and
the height divided by the width is at least approximately two.

6. The process of claim 1, further **characterised by**:
rinsing the substrate (10) after reducing the portion of the seed film (34) and before forming the conductive film (76); and
transferring the substrate (10) to a reactor for forming the conductive film (76),
wherein no more than approximately two minutes lapses between the end of rinsing the substrate (10) and forming the conductive film (76).

7. The process of claim 1, wherein reducing the portion of the seed film comprises:
placing the substrate (10) into a solution (59) within a bath (50), wherein the substrate (10) is at least part of a cathode of the bath (50); and
flowing current between an anode (54) and the cathode of the bath (50).

8. The process of claim 7, wherein the solution (59) includes an electrolyte capable of ionizing into cations and anions, wherein:
the cations are selected from a group consisting of sodium, potassium, aluminum, and ammonium ions; and
the anions are selected from a group consisting of fluoride, carbonate, bicarbonate, sulfate, phosphite, phosphate, borate, and citrate.

9. The process of claim 7, wherein the solution includes an electrolyte selected from a group consisting of NaHCO₃ and Na₂SO₄.

10. The process of claim 1, 2, 3, 4, 5, 6, 7, 8, or 9, wherein the seed film (34) includes copper.

## Patentansprüche

1. Verfahren zum Bilden einer Halbleitervorrichtung, **gekennzeichnet durch**:
Bilden eines Keimfilms (34) über einem Substrat (10), wobei ein Teil des Keimfilms (34) oxidiert wird;
Reduzieren des Teils des Keimfilms (34); und
Bilden eines leitenden Films (76) über dem Keimfilm (34).

2. Verfahren nach Anspruch 1, weiterhin **gekennzeichnet durch** das Aussetzen des Keimfilms (34) zu Luft, bevor der Teil des Keimfilms (34) reduziert wird.

3. Verfahren nach Anspruch 1, weiterhin **gekennzeichnet durch** das Bilden einer gemusterten Isolierschicht (11) über dem Substrat (10), bevor die Keimschicht (34) gebildet wird, wobei die gemusterte Isolierschicht (11) eine Öffnung umfasst.

4. Verfahren nach Anspruch 3, bei dem:
die Öffnung eine Höhe und eine Breite aufweist; und
die Höhe dividiert durch die Breite zumindest ungefähr zwei ist.

5. Verfahren nach Anspruch 3, bei dem:
die Öffnung eine dualeingelegte Öffnung ist, die einen Durchgangsteil umfasst, der durch einen Boden und Wände definiert wird, die an die Öffnung angrenzen;
der Durchgangsteil eine Höhe und eine Breite aufweist; und
die Höhe dividiert durch die Breite zumindest ungefähr zwei ist.

6. Verfahren nach Anspruch 1, weiterhin **gekennzeichnet durch**:
Spülen des Substrats (10) nach dem Reduzieren des Teils des Keimfilms (34) und vor der Bildung des leitenden Films (76); und
Transferieren des Substrats (10) zu einem Reaktor, zum Bilden des leitenden Films (76);
wobei nicht mehr als ungefähr zwei Minuten zwischen dem Ende des Spülens des Substrats (10) und des Bildens des leitenden Films (76) vergehen.

7. Verfahren nach Anspruch 1, bei dem das Reduzieren des Teils des Keimfilms umfasst:
Anordnen des Substrats (10) in einer Lösung (59) innerhalb eines Bades (50), wobei das Substrat (10) zumindest Teil einer Kathode des Bades (50) ist; und
Erzeugen eines Stromflusses zwischen einer Anode (54) und der Kathode des Bades (50).

8. Verfahren nach Anspruch 7, bei dem die Lösung (59) ein Elektrolyt umfasst, das zur Ionisierung in Kationen und Anionen geeignet ist, wobei:
die Kationen aus einer Gruppe ausgewählt werden, die aus Natrium, Kalium, Aluminium und Amoniumionen besteht; und
die Anionen aus einer Gruppe ausgewählt werden, die aus Fluorid, Karbonat, Bikarbonat, Sulfat, Phosphit, Phosphat, Borat und Citrat besteht.

9. Verfahren nach Anspruch 7, bei dem die Lösung ein Elektrolyt umfasst, das aus einer Gruppe ausgewählt ist, die aus NaHCO₃ und Na₂SO₄ besteht.

10. Verfahren nach Anspruch 1, 2, 3, 4, 5, 6, 7, 8 oder 9, bei dem der Keimfilm (34) Kupfer umfasst.

## Revendications

1. Procédé de formation d'un dispositif semi-conducteur, **caractérisé par** les étapes qui consistent à :
former un film de germination (34) sur un substrat (10), une partie du film de germination (34) étant oxydée ;
réduire la partie du film de germination (34) ; et
former un film conducteur (76) sur le film de germination (34).

2. Procédé selon la revendication 1, **caractérisé, en outre, par** l'étape qui consiste à exposer le film de germination (34) à l'air avant de réduire la partie du film de germination (34).

3. Procédé selon la revendication 1, **caractérisé, en outre, par** l'étape qui consiste à former une couche d'isolation structurée (11) sur le substrat (10) avant de former la couche de germination (34), la couche d'isolation structurée (11) comprenant une ouverture.

4. Procédé selon la revendication 3, dans lequel :
l'ouverture a une certaine hauteur et une certaine largeur ; et
le rapport de la hauteur divisé par la largeur est égal à au moins environ deux.

5. Procédé selon la revendication 3, dans lequel :
l'ouverture est une ouverture encastrée double, qui comprend une partie formant via, définie par un fond et des parois venant jusqu'au niveau de l'ouverture ;
la partie formant via a une certaine hauteur et une certaine largeur ; et
le rapport de la hauteur divisé par la largeur est égal à au moins environ deux.

6. Procédé selon la revendication 1, **caractérisé, en outre, par** les étapes qui consistent à :
rincer le substrat (10) après la réduction de la partie du film de germination (34) et avant la formation du film conducteur (76) ; et
transférer le substrat (10) dans un réacteur, pour former le film conducteur (76),
où il n'y a pas plus d'environ deux minutes d'attente entre la fin du rinçage du substrat (10) et la formation du film conducteur (76).

7. Procédé selon la revendication 1, dans lequel l'étape de réduction de la partie du film de germination comprend les opérations qui consistent à :
placer le substrat (10) dans une solution (59) à l'intérieur d'un bain (50), le substrat (10) constituant au moins une partie d'une cathode du bain (50) ; et
faire circuler le courant entre une anode (54) et la cathode du bain (50).

8. Procédé selon la revendication 7, dans lequel la solution (59) comprend un électrolyte capable de s'ioniser en cations et en anions, où :
les cations sont choisis dans le groupe comprenant les ions sodium, potassium, aluminium, et ammonium ; et
les anions sont choisis dans le groupe comprenant les ions fluorure, carbonate, bicarbonate, sulfate, phosphite, phosphate, borate, le citrate.

9. Procédé selon la revendication 7, dans lequel la solution comprend un électrolyte choisi dans le groupe comprenant le NaHCO₃ et le Na₂SO₄.

10. Procédé selon la revendication 1, 2, 3, 4, 5, 6, 7, 8 ou 9, dans lequel le film de germination (34) comprend du cuivre.
